(19) Europäisches Patentamt
European Patent Office
Office européen des brevets

(11) **EP 2 910 957 A1**

(12) **EUROPEAN PATENT APPLICATION**
published in accordance with Art. 153(4) EPC

(43) Date of publication:
**26.08.2015 Bulletin 2015/35**

(51) Int Cl.:
**G01R 19/00** (2006.01)

(21) Application number: **13846830.1**

(22) Date of filing: **01.10.2013**

(86) International application number:
**PCT/JP2013/005845**

(87) International publication number:
**WO 2014/061214 (24.04.2014 Gazette 2014/17)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **18.10.2012 JP 2012231023**

(71) Applicants:
• **Advance Create Inc.**
**Tokyo 140-0004 (JP)**

• **LABROS Inc.**
**Chiyoda-ku**
**Tokyo 101-0025 (JP)**

(72) Inventors:
• **SATO, Hideki**
**Tokyo 140-0004 (JP)**
• **KAJI, Toshiyuki**
**Tokyo 140-0004 (JP)**

(74) Representative: **Oppermann, Frank**
**OANDO Oppermann & Oppermann LLP**
**Washingtonstrasse 75**
**65189 Wiesbaden (DE)**

(54) **POWER FAILURE DETECTION METHOD, POWER FAILURE DETECTOR, LIGHTING DEVICE, AND POWER SUPPLY DEVICE**

(57)    Provided are a power failure detection method, a power failure detector, a lighting device, and a power supply device capable of detecting a power failure regardless of a state of a power switch without a need of interior wiring work. The power failure detector includes a reference voltage storing part 29 storing as a reference voltage state at least one of weak voltages that are generated due to an inter-wire capacity induction and an inter-wire electromagnetic induction of a wiring of interior wirings on a ground side N and a wiring of the interior wirings on a non-ground side L into which a wall switch is interposed and that are detected in an OFF state of the wall switch during a non-power failure, a monitored voltage detection part 29 monitoring and detecting as a monitored voltage state at least one of week voltages that are generated due to the inter-wire capacity induction and the inter-wire electromagnetic induction, and a power failure determination part 29 determining a power failure by comparing the reference voltage state and the monitored voltage state.

[FIG.10]

**Description**

FIELD OF THE INVENTION

The present invention relates to a power failure detection method and a power failure detector that detect a power failure state, and a lighting device and a power supply device that are operable even during a power failure.

BACKGROUND OF THE INVENTION

Conventionally, there are ones disclosed in patent documents 1 to 3 as this kind of method. The power failure detection method connects an impedance element to a power switch of a lighting device in parallel and grasps a voltage value or current value through the impedance element, thereby to detect whether the power is lost.

Even this conventional technique can put the light on and off with a switch on a wall during a non-power failure, and can put the light on regardless of a state of the switch on the wall during a power failure.

However, there is a need to add the impedance such as a resistor or neon bulb to the switch on the wall and a need of interior wiring work to the wall switch. Such a wiring modification for the alternate current wire has to be conducted by a licensed electrical worker according to the regulation of the building. For this reason, the economic burden is large because there is a case where the work cost easily exceeds the expense for the emergency lighting device and the temporal burden from the purchase of the emergency lighting device to the actual usage state cannot be ignored.

In contrast, there is one that is realized without change of a switch on a wall.

However, since it puts the light on during the power failure only when the switch on the wall is in the turn-on state, the aim cannot be realized.

Further, there is one disclosed in a patent document 4 as a power failure detection method that does not need to connect an impedance element to a switch in parallel. This detection method detects impedance between commercial power wires to detect whether the power is lost.

However, it cannot detect the power failure when the power is lost while a power switch is open i.e. the power failure when the power is lost while the lighting device with the emergency lighting function is unlit. For this reason, there is a problem to cause the delay in assessment of the situation at short times or first motion when a power failure is caused by disaster such as, in particular, earthquake while sleeping at midnight or before dawn.

PRIOR ART DOCUMENT

PATENT DOCUMENT

PATENT DOCUMENT 1: JP S54-069736 A
PATENT DOCUMENT 2: JP 4776609 B
PATENT DOCUMENT 3: JP 2012-28292 A
PATENT DOCUMENT 4: JP H08-264010 A

SUMMARY OF THE INVENTION

PROBLEM TO BE SOLVED BY THE INVENTION

A problem to be solved is that the interior wiring work is needed and the burden is large though the light is put on regardless of a state of the switch on the wall during a power failure.

MEANS FOR SOLVING THE PROBLEM

The present invention provides a power failure detection method in order to detect a power failure regardless of a state of a power switch without a need of interior wiring work. The power failure detection method comprises comparing a reference voltage state, at least one of weak voltages of which are generated due to an inter-wire capacity induction and an inter-wire electromagnetic induction of a wiring of interior wirings on a ground side and a wiring of the interior wirings on a non-ground side into which a power switch of an electric device is interposed and that are detected in an OFF state of the power switch during a non-power failure, and a monitored voltage state, at least one of week voltages of which are generated due to the inter-wire capacity induction and the inter-wire electromagnetic induction and monitored to be detected, thereby to detect a power failure.

The present invention provides a power failure detector comprising a reference voltage storing part storing as a reference voltage state at least one of weak voltages that are generated due to an inter-wire capacity induction and an inter-wire electromagnetic induction of a wiring of interior wirings on a ground side and a wiring of the interior wirings on a non-ground side into which a power switch is interposed and that are detected in an OFF state of the power switch during a non-power failure, a monitored voltage detection part monitoring and detecting as a monitored voltage state at least one of week voltages that are generated due to the inter-wire capacity induction and the inter-wire electromagnetic induction, and a power failure determination part determining a power failure by comparing the reference voltage state and the monitored voltage state.

The present invention provides a lighting device using the power failure detector. The lighting device comprises the reference voltage storing part, the monitored voltage detection part and the power failure determination part, an input connection part being connectable and disconnectable to the interior wirings, a battery charged when a connection is established to the interior wirings through the input connection part, a lamp lit by receiving power fed through one of a power feeding path led from the input connection part and a power feeding path led from the battery, to be lit, and a power feeding switching part making a switch so that the power is fed to the lamp through the power feeding path led from the input connection part if the power failure determination part determines a non-power failure and the power is fed to the lamp through the power feeding path led from the battery if the power failure determination part determines a power failure.

The present invention provides a power supply device using the power failure detector. The power supply device comprises the reference voltage storing part, the monitored voltage detection part and the power failure determination part, an input connection part being connectable and disconnectable to the interior wirings, a battery charged when a connection is established to the interior wirings through the input connection part, an output connection part receiving and outputting power fed through one of a power feeding path led from the input connection part and a power feeding path led from the battery, and a power feeding switching part making a switch so that the power is output from the output connection part through the power feeding path led from the input connection part if the power failure determination part determines a non-power failure and the power is output from the output connection part through the power feeding path led from the battery if the power failure determination part determines a power failure.

EFFECT OF THE INVENTION

The power failure detection method of the present invention, because of the aforementioned configuration, can detect a power failure by comparing the reference voltage state and the monitored voltage state according to at least one of the weak voltages generated due to the inter-wire capacity induction and the inter-wire electromagnetic induction. It is capable of detecting the power failure regardless of a state of the power switch without a need of interior wiring work.

The power failure detector of the present invention can determine a power failure by comparing the reference voltage state of the reference voltage storing part and the monitored voltage state of the monitored voltage determination part.

The lighting device of the present invention can determine a power failure by comparing the reference voltage state of the reference voltage storing part and the monitored voltage state of the monitored voltage determination part.

The power feeding switching part makes a switch so that the power is fed to the lamp through the power feeding path led from the input connection part if the power failure determination part determines a non-power failure and the power is fed to the lamp through the power feeding path led from the battery if the power failure determination part determines a power failure. This is capable of lighting the lamp regardless of a state of the power switch during a power failure.

The power feeding switching part makes a switch so that the power is output from the output connection part through the power feeding path led from the input connection part if the power failure determination part determines a non-power failure and the power is output from the output connection part through the power feeding path led from the battery if the power failure determination part determines a power failure. This is capable of feeding power from the output connection part regardless of a state of the power switch and lighting the lamp or the like connected to the output connection part.

BRIEF DESCRIPTION OF THE DRAWINGS

[FIG. 1] It is a block diagram in a state where a power failure detector is connected to interior wirings. (Embodiment 1)
[FIG. 2] It is an explanatory diagram for a principle of an inter-wire electromagnetic induction. (Embodiment 1)
[FIG. 3] It is an explanatory diagram for a principle of an inter-wire capacity induction. (Embodiment 1)
[FIG. 4] It is an example of waveforms of the power failure detector in which(A) is a block diagram illustrating a state of a wall switch and the like, (B) is a waveform showing a ground side voltage and (C) is a waveform showing an inter-wire voltage. (Embodiment 1)
[FIG. 5] It is an example of waveforms of the power failure detector in which(A) is a block diagram illustrating a state of a wall switch and the like, (B) is a waveform showing a ground side voltage and (C) is a waveform showing an inter-wire voltage. (Embodiment 1)
[FIG. 6] It is an example of waveforms of the power failure detector in which(A) is a block diagram illustrating a state of a wall switch and the like, (B) is a waveform showing a ground side voltage and (C) is a waveform showing an inter-wire voltage. (Embodiment 1)
[FIG. 7] It is an example of waveforms of the power failure detector in which(A) is a block diagram illustrating a state of a wall switch and the like, (B) is a waveform showing a ground side voltage and (C) is a waveform showing an inter-wire voltage. (Embodiment 1)
[FIG. 8] It is an example of waveforms of the power failure detector in which (A) is a block diagram illustrating a state of a wall switch and the like, (B) is a waveform showing a ground side voltage and (C) is a waveform showing an inter-wire voltage. (Embodiment 1)

[FIG. 9] It is an example of waveforms of the power failure detector in which(A) is a block diagram illustrating a state of a wall switch and the like, (B) is a waveform showing a ground side voltage and (C) is a waveform showing an inter-wire voltage. (Embodiment 1)

[FIG. 10] It is a block diagram of the power failure detector. (Embodiment 1)

[FIG. 11] It is a block diagram of a lighting device. (Embodiment 2)

[FIG. 12] It is a block diagram of a power supply device. (Embodiment 3)

[FIG. 13] It is a block diagram of a power supply device. (Embodiment 3)

EMBODIMENT FOR CARRYING OUT THE INVENTION

The object that is to detect a power failure regardless of a state of a power switch without a need of interior wiring work is accomplished by a reference voltage storing part 29 storing as a reference voltage state at least one of weak voltages that are generated due to an inter-wire capacity induction and an inter-wire electromagnetic induction of a wiring 3 of interior wirings 3 and 5 on a ground side N and a wiring 5 of the interior wirings on a non-ground side L into which a wall switch 19 is interposed and that are detected in an OFF state of the wall switch 19 during a non-power failure, a monitored voltage detection part 29 monitoring and detecting as a monitored voltage state at least one of week voltages that are generated due to the inter-wire capacity induction and the inter-wire electromagnetic induction, and a power failure determination part 29 determining a power failure by comparing the reference voltage state and the monitored voltage state.

EMBODIMENT 1

[Power failure detection principle and method]

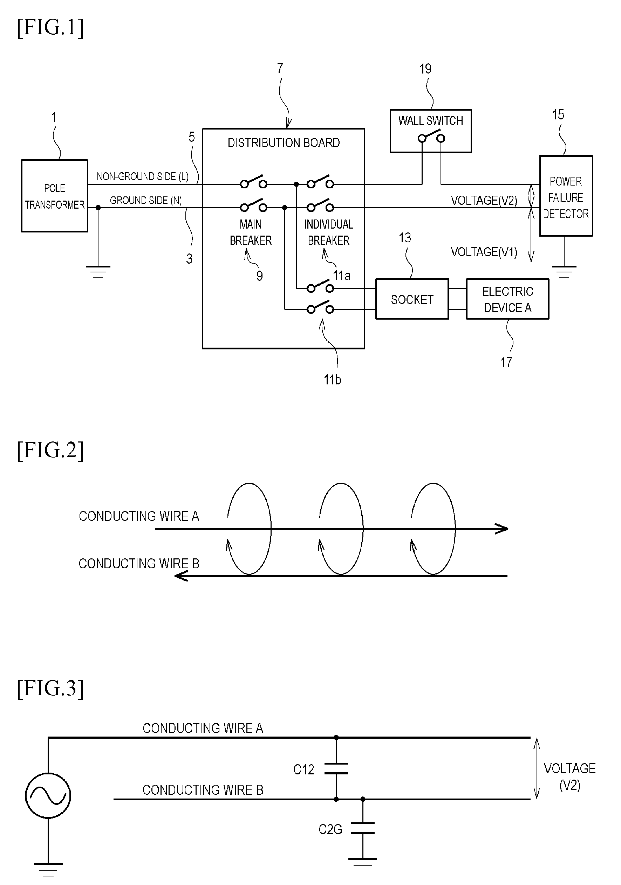

FIG. 1 is a block diagram in a state where a power failure detector is connected to interior wirings.

As illustrated in FIG. 1, general household wiring is wired through a pole transformer 1 to a high voltage line. The power is transformed from the line high voltage to 100V at the pole transformer 1 and then is fed. For the sake of safety, the wiring 3 on one side of the pole transformer 1 is grounded. This is referred to as one on the ground side N. The wiring 5 on the other side is referred to as one on the non-ground side L.

The wirings 3 and 5 from the pole transformer 1 pass through a main breaker 9, and individual breakers 11a, 11b...on a distribution board 7 and the wirings are provided with a socket 13 and a power failure detector 15 on a lighting device side connected thereto. To the socket 13, for example, an electric device 17 is connected.

Into the non-ground side L of the power failure detector 15, a wall switch 19 is provided as a power switch for lighting.

In normal use, AC 100V is fed from the pole transformer 1 and a non-power failure state is determined when the main breaker 9 and the individual breakers 11a, 11b... are not cut off, to put the light on and off by turning the wall switch 19 on and off.

In a power failure, the lighting device is lit by the power of the battery regardless of the on/off state of the wall switch 19.

As the power failure, there are two types in which one is a case where the power is not fed from the pole transformer 1 and the other is a case where the main breaker 9 and the individual breaker 11a for feeding the power to the lighting device are cut off.

For the interior wirings from the distribution board 7 to the lighting device, a cable such as VVF cable in which a plurality of insulated electric wires are collected into one is used.

If the electric wires are collected in parallel, a coupling phenomenon is caused between the electric wires to generate a current and/or a voltage by a signal on one side affecting the other side due to the inter-wire electromagnetic induction and/or the inter-wire capacity induction.

In the power failure detection method according to the embodiment of the present invention, the power failure is detected by detecting the inter-wire electromagnetic induction and/or the inter-wire capacity induction between the wirings.

With this feature, there is no need for interior wiring work and the like and a power failure can be determined regardless of the ON/OFF state of the wall switch 9.

(Inter-wire electromagnetic induction)

FIG. 2 is an explanatory diagram for a principle of the inter-wire electromagnetic induction.

When a current flows in a conducting wire A, a magnetic field is generated around the conducting wire. If the current flowing in the conducting wire A is an alternate current, an electro motive force is generated in a conducting wire B with respect to change in the magnetic field.

Namely, in FIG. 1, when the electric device 17 operates at a destination branched at the distribution board 7, a weak voltage V1 is generated due to the inter-wire electromagnetic induction between the ground and the wiring 3 on the ground side N that is grounded to primarily generate no voltage due to an electromagnetic induction from the pole transformer 1 up to the electric device 17.

(Inter-wire capacity induction)

FIG. 3 is an explanatory diagram for a principle of the inter-wire capacity induction.

When an alternate voltage is applied to a conducting wire A in a cable relative to the ground in a case where a conducting wire B exists in the same cable, there is an electrostatic capacitance C12 between the conducting wire A and the conducting wire B. Further, there is an electrostatic capacitance C2G between a ground or a structural object such as building through which the cable passes and the conducting wire B. Therefore, in a case where the conducting wire B is completely insulated from the conducting wire A and the earth and the like i.e. when the wall switch 19 is in the OFF state, a voltage V2 between the conducting wires A and B is expressed as the following equation.

$$V2=V\times(C2G/C12+C2G)$$

In addition, the value of V2 becomes 0V at the time of a power failure because the value of V becomes 0V in principle.

The inter-wire electrostatic capacitance is an electrostatic capacitance generated between two lines and, in a case of the VVF cable, a small capacitance in the degree of about 50pF to 200pF at the length of 1m. Each wiring has an electrostatic capacitance using a structure object such as building as a part of the ground.

Namely, in FIG. 1, a weak voltage V2 is generated between the wiring 3 on the ground side N and the wiring 5 on the non-ground side L cut off by the wall switch 19.

When no power is fed from the pole transformer 1, the electromagnetic induction or the like is not caused and the voltages V1 and V2 are approximate 0. Further, when the individual breaker 11a is cut off, the voltages V1 and V2 are reduced though there is a slight influence of the other interior wirings.

(Power failure detection method)

As the power failure detection method, it detects and uses both or any one of the voltage V1 between the ground and the wiring 3 on the ground side N and the voltage V2 between the wiring 3 on the ground side N and the wiring 5 on the non-ground side L cut off by the wall switch 19.

The embodiment of the present invention measures the weak voltage generated in the wiring 3 on the ground side N due to the aforementioned inter-wire electromagnetic induction and/or inter-wire capacity induction, to detect a power failure.

Namely, at least one of the weak voltages V1 and V2 generated due to the inter-wire electromagnetic induction and inter-wire capacity induction of the wiring 3 of the interior wiring on the ground side N and the wiring 5 of the interior wiring on the non-ground side L into which the wall switch 19 of the lighting device is interposed is detected as the reference voltage state in the OFF state of the wall switch 19 during the non-power failure. Next, at least one of the week voltages V1 and V2 generated due to the inter-wire capacity induction and the inter-wire electromagnetic induction is monitored and detected as the monitored voltage state. Then, a power failure is detected by comparing the reference voltage state and the monitored voltage state.

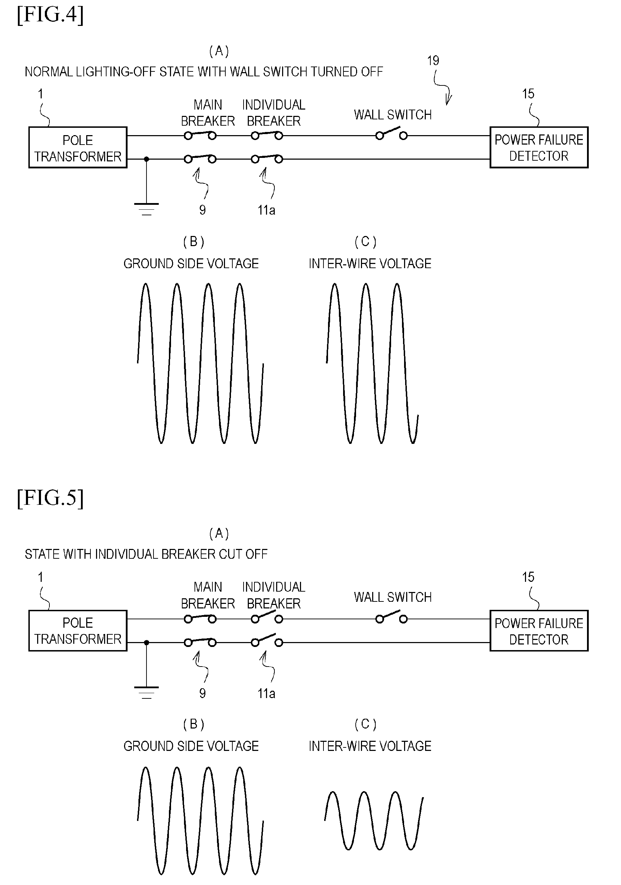

The details are illustrated as FIGs. 4-9. FIGs. 4-9 are examples of waveforms of the power failure detector in which each one (A) is a block diagram illustrating a state of the wall switch and the like, each one (B) is a waveform showing a voltage on the ground side and each one (C) is a waveform showing the inter-wire voltage.

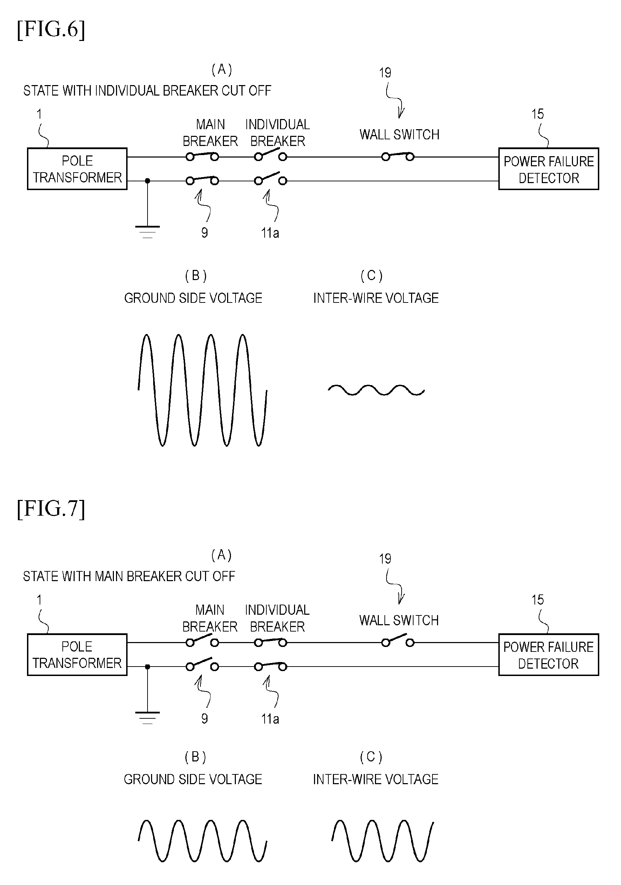

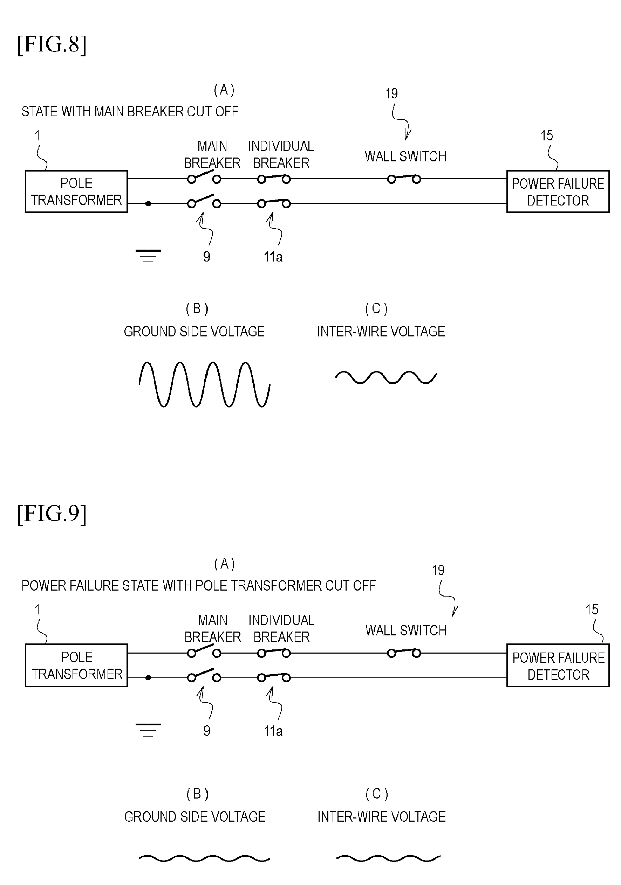

FIG. 4(A) is a normal lighting-off state with the wall switch 19 turned off, FIG. 5(A) is a state with the individual breaker 11a cut off and the wall switch 19 turned off, FIG. 6(A) is a state with the individual breaker 11a cur off and the wall switch 19 turned on, FIG. 7(A) is a state with the main breaker 9 cut off and the wall switch 19 turned off, FIG. 8(A) is a state with the main breaker 9 cut off and the wall switch 19 turned on, and FIG. 9(A) is a state with the pole transformer 1 cut off.

The ground side voltages V1 in the states of FIGs. 4(A)-8(A) are in the waveform states of FIGs. 4(B)-8(B).

The inter-wire voltages V2 in the states of FIGs. 4(A)-8(A) are in the waveform states of FIGs. 4(C)-8(C).

From such waveform states of the voltages V1 and V2 of FIGs. 4-8, the voltages V1 and V2 of FIG. 4 are stored as the reference voltage state and then the voltages V1 and V2 as illustrated in FIGs. 5-8 are monitored and detected as the monitored voltage states. By comparing these reference voltage state and monitored voltage state, a power failure is detected. For example, it determines a power failure when any one of the monitored ground side voltage V1 or inter-wire voltage V2 becomes one-half or less by comparison with the reference voltage at the time of the wall switch 19 turned off.

In addition, the voltage value to be measured varies according to the actual connected electric device and length of the interior wiring. For this, it may add a function to automatically correct and adjust a threshold based on the stored voltage value of the lighting-off state of the non-power failure and a variation width of a measured voltage, the threshold distinguishing the lighting-off state of the non-power failure from a power failure.

As a higher-level determination method, it may add a function to store the voltage value waveform during the non-power failure as the reference voltage state, use a voltage waveform that is being measured through the monitoring as the monitored voltage state, and determine a power failure according to the difference between both the waveforms.

[Power failure detector]

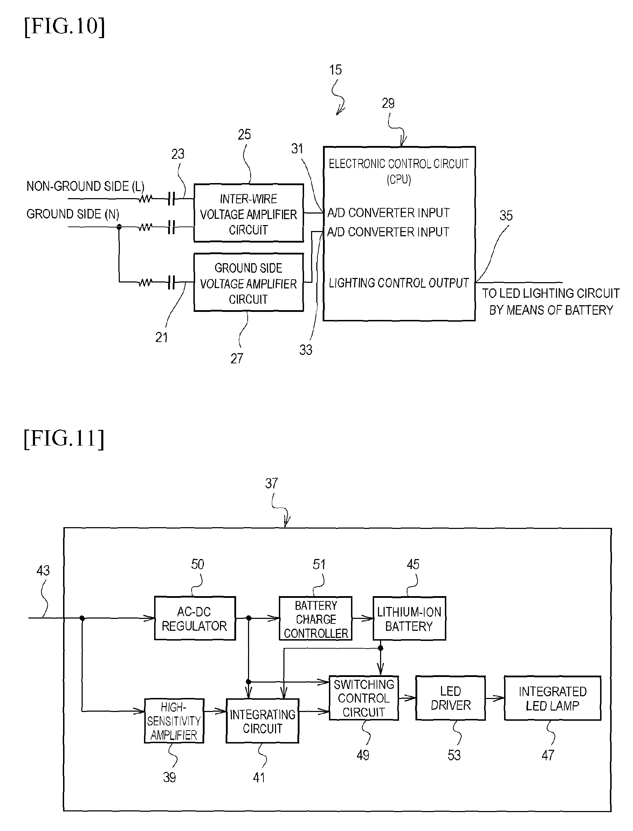

FIG. 10 is a block diagram of the power failure detector.

The power failure detector 15 implementing the power failure detection method according to the embodiment of the present invention is provided with input terminals 21 and 23, an inter-wire voltage amplifier circuit 25, a ground side voltage amplifier circuit 27, and an electronic control circuit 29.

The input terminal 21 is connected to the wiring 3 (FIG. 1) on the ground side N of AC 100V, and the input terminal 23 is connected to the wiring 5 (FIG. 1) on the non-ground side L of AC 100V. In addition, the input terminals 21 and 23 are connected through a DC coupling condenser and a resistor to restrict a current for the sake of safety because the voltage of AC 100V is input during the normal lighting-on state.

The inter-wire voltage amplifier circuit 25 receives an input on the ground side N and the non-ground side L and amplifies the voltage difference V2 between the wiring 3 on the ground side N and the wiring 5 on the non-ground side L to input it to the electronic control circuit 29.

The ground side voltage amplifier circuit 27 receives an input on the ground side N and amplifies the voltage difference V1 between the ground side N and a GND of the detector 15 corresponding to a virtual earth to input it to the electronic control circuit 29.

The electronic control circuit 29 comprises a CPU, memories and the like and is provided with A/D converter input terminals 31 and 33 and an output terminal 35.

The A/D converter input terminals 31 and 33 is to input the outputs from the inter-wire voltage amplifier circuit 25 and the ground side voltage amplifier circuit 27.

The CPU configures the monitored voltage detection part and the power failure determination part. As the monitored voltage detection part, it monitors at least one of the weak voltages that are generated due to the inter-wire capacity induction and the inter-wire electromagnetic induction. According to the embodiment, it monitors the input from the inter-wire voltage amplifier circuit 25 as the voltage generated due to the inter-wire capacity induction and the input from the ground side voltage amplifier circuit 27 as the voltage generated due to the inter-wire electromagnetic induction.

The CPU as the power failure determination part compares the reference voltage state and the monitored voltage state to determine a power failure.

In regard to the reference voltage state, the memory as the reference voltage storing part stores at least one of the weak voltages that are generated due to the inter-wire capacity induction and the inter-wire electromagnetic induction of the ground side N of the interior wirings and the non-ground side L of the interior wirings into which the power switch is interposed and that are detected in the OFF state of the power switch during the non-power failure. According to the embodiment, the input from the inter-wire voltage amplifier circuit 25 is detected in the OFF state of the wall switch 19 and is stored, and the input from the ground side voltage amplifier circuit 27 is detected to store the reference voltages of the voltages V2 and V1.

The monitored voltage state is the monitored voltages that are monitored after storing the reference voltage state as mentioned above and input from the inter-wire voltage amplifier circuit 25 and the ground side voltage amplifier circuit 27. The CPU reads out the reference voltages and compares the reference voltages with the monitored voltages to determine a power failure. In this determination, it determines that there is a power failure when the monitored voltages become less than the reference voltages as illustrated in FIGs. 4-8. The determination result is output as a power failure signal from the output terminal 35.

The CPU can removes noise with a filter of 50Hz or 60Hz from the waveforms input through the A/D converter input terminals 31 and 33 and calculate amplitude, an average value and the like based on the waveforms from which the noise has been removed.

Incidentally, it employs the configuration using the CPU to determine a power failure. However, it may be configured by an analog circuit. The reason why the CPU is used is because the higher-level power failure determination can be carried out at a less cost than the analog circuit.

The power failure detector 15 with such a configuration is connected to the ground side N and the non-ground side L of AC 100V in order to detect a power failure.

The voltage V2 is amplified by the inter-wire voltage amplifier circuit 25 and is input from the A/D converter input terminal 31 to the electronic control circuit 29, and the voltage difference V1 is amplified by the ground side voltage amplifier circuit 27 and is input from the A/D converter input terminal 33 to the electronic control circuit 29.

At the electronic control circuit 29, the noise is removed with the filter of 50Hz or 60Hz from the waveforms input into the CPU.

The amplitude, the average value and the like are calculated using the waveforms from which the noise has been removed.

Since the value to be measured varies according to the actual connected electric device and length of the interior wirings, the voltage value is measured in the lighting-off state during the non-power failure and is stored in the memory as the reference voltage.

If the variation width of the voltage is large, it changes the amplification factor of the amplifier circuit.

When a value that is smaller than the stored value in the non-power failure state is measured, a power failure is determined to perform an output from the output terminal 35 to a controller that puts the light on by means of the battery.

In this way, the CPU is required to store the weak reference voltage values detected during the non-power failure and the power-off based on the wall switch 19, compare in magnitude the stored reference voltage values with the monitored voltage values detected by monitoring, determine a power failure if it detects the weaker voltage value than a preset threshold by comparing the monitored voltage values and the reference voltage values, and execute arithmetic processing and control processing for outputting an arbitrary signal to a subsequent circuit.

It may add to the CPU a function to automatically correct or adjust a threshold to distinguish the lighting-off state during the non-power failure from a power failure.

EMBODIMENT 2

FIG. 11 is a block diagram of a lighting device according to Embodiment 2.

The lighting device of FIG. 11 is a LED lighting device 37 using the power failure detector of Embodiment 1.

The LED lighting device 37 is provided with a high-sensitivity amplifier 39 and an integrating circuit 41 corresponding to the power failure detector 15 of Embodiment 1. The high-sensitivity amplifier 39 corresponds to the inter-wire voltage amplifier circuit 25 and the ground side voltage amplifier circuit 27, the integrating circuit 41 corresponds to the electronic control circuit 29 composed of the CPU and the like, and they function in the same way as Embodiment 1. The integrating circuit 41, therefore, is configured to include the reference voltage storing part, the monitored voltage detection part and the power failure determination part.

The LED lighting device 37 is further provided with an input connection part 43, a lithium-ion battery 45 as battery, an integrated LED lamp 47 as lamp, and a switching control circuit 49 as power feeding switching part.

The input connection part 43 is inserted into and connected to an arbitrary socket that is provided indoors so as to be connectable and disconnectable to the interior wirings.

The lithium-ion battery 45 lights the integrated LED lamp 47 at the time of a power failure and is charged when establishing the connection to the interior wirings through the input connection part 43. Namely, the lithium-ion battery 45 is charged from the input connection part 43 through an AC-DC regulator 50 and a battery charge controller 51.

The integrated LED lamp 47 receives a fed power from any one of a power feeding path led from the input connection part 43 and a power feeding path led from the lithium-ion battery 45, and is driven by a LED driver 53 to be lit. In the feeding path led from the input connection part 43, power is distributed to the LED driver 53 through the input connection part 43, the AC-D regulator 50 and the switching control circuit 49. In the feeding path led from the lithium-ion battery 45, power is distributed to the LED driver 53 from the lithium-ion battery 45 through the switching control circuit 49.

The switching control circuit 49 switches between the power feeding paths to the integrated LED lamp 47. When the integrating circuit 41 as the power failure determination part determines the non-power failure, the switching control circuit 49 makes the switch so that the power is distributed to the integrated LED lamp 47 through the power feeding path led from the input connection part 43. When the integrating circuit 41 as the power failure determination part determines a power failure, the switching control circuit 49 makes the switch so that the power is distributed to the integrated LED lamp 47 through the power feeding path led from the lithium-ion battery 45.

The LED lighting device 37 with such a configuration can be used by being attached to a ceiling socket, a clip-in ceiling socket, or the like according to the input connection part 43, and it needs no special electric work.

The lithium-ion battery 45 is charged by the battery charge controller 51 during the non-power failure.

During the non-power failure, the integrated LED lamp 47 is lit through the power feeding path led from the input connection part 43 and the ON-OFF control of the integrated LED lamp 47 is carried out by the wall switch.

During a power failure, the switching control circuit 49 receives a signal from the integrating circuit 41 and makes the switch between the power feeding paths.

During the power failure, the integrated LED lamp 47 is automatically lit through the power feeding path led from the lithium-ion battery 45, to realize the lighting device with the emergency lighting function. The LED lighting device 37 itself is disconnected from the socket to function as an electric torch. The LED lighting device 37, however, may be configured as a fixed emergency light.

An ON-OFF button may be added to the LED lighting device 37. The ON-OFF control may be performed by remote control.

In addition, the LED lighting device 37 may be configured so that light intensity and lighting time of the lighting device during a power failure is adjustable by a battery type and battery capacity or an adjustment of the amount of the current to light-emitting elements.

Further, any types of shape, size and the like may be selected for an input plug of the input connection part 43. The input plug may be adapted to any types of light socket that are used in standard homes, offices or the like.

A motion sensor and/or an illuminance sensor may be added to the LED lighting device 37 to automatically perform the ON-OFF control so as not to fulfill the emergency lighting function during a power failure when there are no people or before it gets dark, thereby to add a function cutting wasteful electricity consumption. Furthermore, a buzzer or the like may be added to alert a power failure when the power failure is detected.

As the lamp, an arbitrary lamp such as incandescent lamp, fluorescent lamp, and LED light may be applied.

Since the LED lighting device 37 according to the embodiment of the present invention never needs interior wiring work, modification of the wall switch or the like, the device can be very easily and instantly attached to lighting equipment that spreads widely among standard homes, offices and the like. This provides the simple lighting device with the emergency lighting function at low cost.

The available time within which the device functions as the emergency light during a power failure may be adjustable by the amount of power consumption of the lighting device during the power failure, a battery type, battery capacity and the like.

EMBODIMENT 3

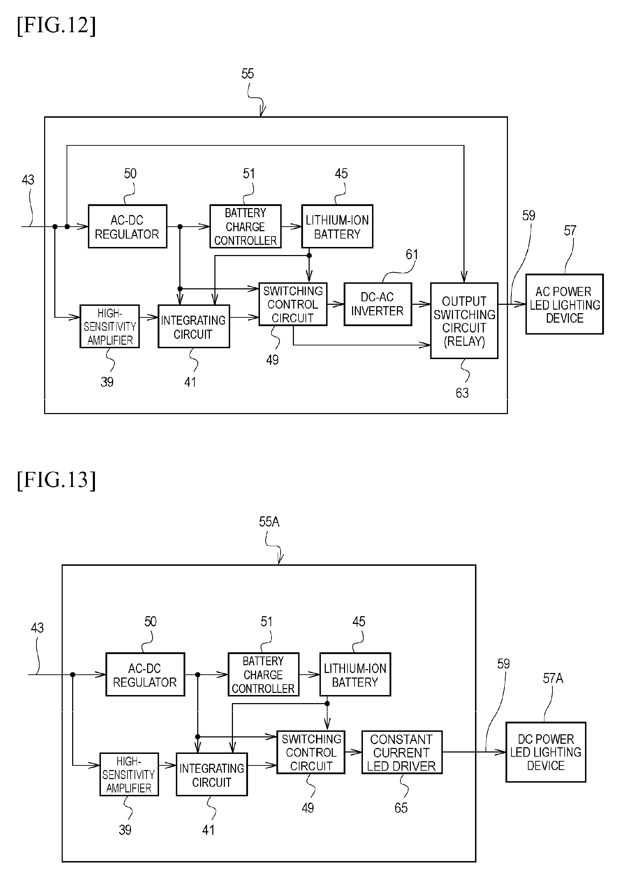

FIG. 12 is a block diagram of a power supply device according to Embodiment 3. In addition, the basic structure is the same as the LED lighting device 37 of Embodiment 2, and therefore, the same components are represented by the same reference numerals to omit duplicate description.

The power supply device 55 of FIG. 12 also uses the power failure detector of Embodiment 1.

The power supply device 55, similar to the LED lighting device 37 of Embodiment 2, has a high-sensitivity amplifier 39 and an integrating circuit 41 corresponding to the power failure detector 15 of Embodiment 1.

The power supply device 55 is further provided with an input connection part 43, a lithium-ion battery 45 as battery, a switching control circuit 49 as power feeding switching part, an AC-DC regulator 50, and a battery charge controller 51, and they function in the same way as Embodiment 2.

On the other hand, the power supply device 55 according to this embodiment, has an external AC power LED lighting device 57, and the power supply device 55 is configured to supply power to the AC power LED lighting device 57. For this, the power supply device 55 has a socket 59 to which the AC power LED lighting device 57 is connected and an output switching circuit 63 configured by a DC-AC inverter 61 and a relay instead of the LED driver 53 and the integrated LED lamp 47 of the LED lighting device 37.

In a power feeding path led from the input connection part 43 according to the embodiment, AC power is directly output from the socket 59 through the input connection part 43 and the output switching circuit 63. In a power feeding path led from the lithium-ion battery 45, the output switching circuit 63 is switched over in conjunction with the switching control circuit 49 at the time of a power failure and then AC power is output from the socket 59 through the lithium-ion battery 45, the switching control circuit 49, the DC-AC inverter 61, and the output switching circuit 63.

With this configuration, the AC power is output from the socket 59 through the power feeding path led from the input connection part 43 to light the external AC power LED lighting device 57 during the non-power failure and allows the ON-OFF control of the AC power LED lighting device 57 to be performed by the wall switch.

During a power failure, the switching control circuit 49 receives a signal from the integrating circuit 41 and then makes the switch between the power feeding paths.

During the power failure, AC power is output from the socket 59 through the power feeding path led from the lithium-ion battery 45 to automatically light the external AC power LED lighting device 57, to realize the emergency light. The power supply device 55 is disconnected from the socket to function as an electric torch together with the AC power LED lighting device 57. The power supply device 55, however, may be configured as a fixed emergency power supply device.

An ON-OFF button may be added to the power supply device 55. The ON-OFF control may be performed by remote control.

The power supply device 55 may be solely disconnected from the socket to be used as a power supply for devices other than the lighting device.

Further, the power supply device 55 may be interposed between the existing lighting device and clip-in ceiling socket, to easily add the emergency lighting function to the lighting device previously used at home or the like.

In this way, this embodiment has no need for interior wiring work and modification of the wall switch or the like and detects a power failure regardless of the ON/OFF state of the power switch.

By cutting off between the AC 100V and the AC power LED lighting device 57 during the OFF state of the power switch, only the power failure detector is connected to an input of the AC 100V. Therefore, this configuration is unaffected by input impedance or the like of the external AC power LED lighting device 57 and contributes stable detection of a power failure.

FIG. 13 is a block diagram of a power supply device according to a modified embodiment of Embodiment 3. In addition, the basic structure is the same as the power supply device 55 of FIG. 12, and therefore, the same components are represented by the same reference numerals to omit duplicate description.

The power supply device 55A of FIG. 13 employs a DC power LED lighting device 57A instead of the AC power LED lighting device 57 of the power supply device 55 of FIG. 12. Accordingly, the DC-AC inverter 61 and the output switching circuit 63 of Fig. 12 are replaced with a constant current LED driver 65 as illustrated in FIG. 13.

In a power feeding path led from the input connection part 43 according to this embodiment, DC power is output from the socket 59 through the input connection part 43, the switching control circuit 49 and the constant current LED driver 65. In a power feeding path led from the lithium-ion battery 45, DC power is output from the socket 59 through the lithium-ion battery 45, switching control circuit 49, and constant current LED driver 65 during a power failure.

With this configuration, the DC power is output from the socket 59 through the power feeding path led from the input connection part 43 to light the external DC power LED lighting device 57A during the non-power failure and allows the ON-OFF control of the DC power LED lighting device 57A to be performed by the wall switch. During a power failure, the switching control circuit 49 receives a signal from the integrating circuit 41 and then makes the switch between the power feeding paths.

During the power failure, DC power is output from the socket 59 through the power feeding path led from the lithium-ion battery 45 to automatically light the external DC power LED lighting device 57A, to realize the emergency light.

The others are the same as the power supply device 55.

DESCRIPTION OF NUMERALS

3, 5     Wiring (interior wirings)
19     Wall switch (power switch)
29     Electronic control circuit (reference voltage storing part, monitored voltage detection part, power failure determination part)
41     Integrating circuit (reference voltage storing part, monitored voltage detection part, power failure determination part)
47     Integrated LED lamp (lamp)
49     Switching control circuit (power feeding switching part)
L     Non-ground side
N     Ground side

**Claims**

1. A power failure detection method comprising:

comparing a reference voltage state, at least one of weak voltages of which are generated due to an inter-wire capacity induction and an inter-wire electromagnetic induction of a wiring of interior wirings on a ground side and a wiring of the interior wirings on a non-ground side into which a power switch of an electric device is interposed and which are detected in an OFF state of the power switch during a non-power failure, and a monitored voltage state, at least one of week voltages of which are generated due to the inter-wire capacity induction and the inter-wire electromagnetic induction and which are monitored to be detected, thereby to detect a power failure.

2. A power failure detector comprising:

a reference voltage storing part storing as a reference voltage state at least one of weak voltages that are generated due to an inter-wire capacity induction and an inter-wire electromagnetic induction of a wiring of interior wirings on a ground side and a wiring of the interior wirings on a non-ground side into which a power switch is interposed and that are detected in an OFF state of the power switch during a non-power failure;
a monitored voltage detection part monitoring and detecting as a monitored voltage state at least one of week voltages that are generated due to the inter-wire capacity induction and the inter-wire electromagnetic induction; and
a power failure determination part determining a power failure by comparing the reference voltage state and the monitored voltage state.

3. A lighting device using the power failure detector set forth in claim 2, comprising:

the reference voltage storing part, the monitored voltage detection part and the power failure determination part;
an input connection part being connectable and disconnectable to the interior wirings;
a battery charged when a connection is established to the interior wirings through the input connection part;
a lamp lit by receiving power fed through one of a power feeding path led from the input connection part and a power feeding path led from the battery; and
a power feeding switching part making a switch so that the power is fed to the lamp through the power feeding path led from the input connection part if the power failure determination part determines a non-power failure and the power is fed to the lamp through the power feeding path led from the battery if the power failure determination part determines a power failure.

4. A power supply device using the power failure detector set forth in claim 2, comprising:

the reference voltage storing part, the monitored voltage detection part and the power failure determination part;
an input connection part being connectable and disconnectable to the interior wirings;
a battery charged when a connection is established to the interior wirings through the input connection part;

an output connection part receiving and outputting power fed through one of a power feeding path led from the input connection part and a power feeding path led from the battery; and

a power feeding switching part making a switch so that the power is output from the output connection part through the power feeding path led from the input connection part if the power failure determination part determines a non-power failure and the power is output from the output connection part through the power feeding path led from the battery if the power failure determination part determines a power failure.

[FIG.1]

```
                                    7                19
                                    |                |
                              DISTRIBUTION BOARD   WALL SWITCH        15
   1                5                                                  |
   |                |                                              POWER
 POLE       NON-GROUND SIDE (L)                                   FAILURE
TRANSFORMER                     MAIN    INDIVIDUAL   VOLTAGE(V2)  DETECTOR
            GROUND SIDE (N)     BREAKER BREAKER
                   |
                   3             9      11a          VOLTAGE(V1)
                                        11b
                                     13
                                   SOCKET    ELECTRIC
                                             DEVICE A
                                               17
```

[FIG.2]

```
CONDUCTING WIRE A  →

CONDUCTING WIRE B  ←
```

[FIG.3]

```
        CONDUCTING WIRE A
                              C12              VOLTAGE
        CONDUCTING WIRE B                        (V2)
                              C2G
```

[FIG.4]

(A)

NORMAL LIGHTING-OFF STATE WITH WALL SWITCH TURNED OFF

1                    MAIN       INDIVIDUAL
                     BREAKER    BREAKER        WALL SWITCH                    19                    15

POLE                                                                              POWER FAILURE
TRANSFORMER                                                                       DETECTOR

                        9          11a

(B)                              (C)
GROUND SIDE VOLTAGE              INTER-WIRE VOLTAGE

[FIG.5]

(A)

STATE WITH INDIVIDUAL BREAKER CUT OFF

1                    MAIN       INDIVIDUAL
                     BREAKER    BREAKER        WALL SWITCH                                          15

POLE                                                                              POWER FAILURE
TRANSFORMER                                                                       DETECTOR

                        9          11a

(B)                              (C)
GROUND SIDE VOLTAGE              INTER-WIRE VOLTAGE

[FIG.6]

(A)
STATE WITH INDIVIDUAL BREAKER CUT OFF

1

POLE TRANSFORMER

MAIN BREAKER    INDIVIDUAL BREAKER

19
WALL SWITCH

15
POWER FAILURE DETECTOR

9    11a

(B)
GROUND SIDE VOLTAGE

(C)
INTER-WIRE VOLTAGE

[FIG.7]

(A)
STATE WITH MAIN BREAKER CUT OFF

1

POLE TRANSFORMER

MAIN BREAKER    INDIVIDUAL BREAKER

19
WALL SWITCH

15
POWER FAILURE DETECTOR

9    11a

(B)
GROUND SIDE VOLTAGE

(C)
INTER-WIRE VOLTAGE

[FIG.8]

(A)
STATE WITH MAIN BREAKER CUT OFF

1
POLE
TRANSFORMER

MAIN      INDIVIDUAL
BREAKER   BREAKER

19
WALL SWITCH

15
POWER FAILURE
DETECTOR

9        11a

(B)
GROUND SIDE VOLTAGE

(C)
INTER-WIRE VOLTAGE

[FIG.9]

(A)
POWER FAILURE STATE WITH POLE TRANSFORMER CUT OFF

1
POLE
TRANSFORMER

MAIN      INDIVIDUAL
BREAKER   BREAKER

19
WALL SWITCH

15
POWER FAILURE
DETECTOR

9        11a

(B)
GROUND SIDE VOLTAGE

(C)
INTER-WIRE VOLTAGE

[FIG.10]

[FIG.11]

[FIG.12]

[FIG.13]

## INTERNATIONAL SEARCH REPORT

International application No.

PCT/JP2013/005845

### A. CLASSIFICATION OF SUBJECT MATTER
*G01R19/00*(2006.01)i

According to International Patent Classification (IPC) or to both national classification and IPC

### B. FIELDS SEARCHED

Minimum documentation searched (classification system followed by classification symbols)
G01R19/00

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2013 |
| Kokai Jitsuyo Shinan Koho | 1971–2013 | Toroku Jitsuyo Shinan Koho | 1994–2013 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2009-165305 A (Mitsumi Electric Co., Ltd.), 23 July 2009 (23.07.2009), entire text; all drawings (Family: none) | 1-4 |
| A | JP 8-313564 A (Diamond Electric Mfg. Corp.), 29 November 1996 (29.11.1996), entire text; all drawings (Family: none) | 1-4 |
| A | JP 2006-349424 A (Toyoji AHEI), 28 December 2006 (28.12.2006), entire text; all drawings & US 2009/0287430 A1 & EP 1898225 A1 & WO 2006/134678 A1 | 1-4 |

☐ Further documents are listed in the continuation of Box C.　　☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 18 December, 2013 (18.12.13) | 07 January, 2014 (07.01.14) |

| Name and mailing address of the ISA/ Japanese Patent Office | Authorized officer |
|---|---|
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP S54069736 A
- JP 4776609 B
- JP 2012028292 A
- JP H08264010 A